# EUROPEAN PATENT APPLICATION

(11) **EP 1 443 809 A2**
(43) Date of publication of application: **04.08.2004**
(21) Application number: 04001625.5
(22) Date of filing: 26.01.2004
(51) Int. Cl.: H05K 1/05, H01L 23/14

(54) **Electronic circuit unit and method for manufacturing the same**

(30) Priority: 03.02.2003 JP 2003026108
(71) Applicant: ALPS ELECTRIC CO., LTD., Tokyo 145-8501 (JP)
(72) Inventor: Iijima, Kouta, Ota-ku, Tokyo 145-8501 (JP); Fujii, Michiya, Ota-ku, Tokyo 145-8501 (JP)
(74) Representative: Klunker . Schmitt-Nilson . Hirsch

(57) **Abstract**

To provide an electronic circuit unit capable both of effectively radiating heat generated from a BCB resin layer and of readily connecting to the ground of an external circuit.

An electronic circuit unit 1 comprises a base plate 2 made of metal, a BCB resin layer 3 provided on a surface of the base plate 2 and having through-holes 3a, a wiring pattern 4 provided on a surface of the BCB resin layer 3, and a plurality of circuit elements, such as a thin film capacitor 5, a thin film resistor 6, and bare chip semiconductors 7 and 8 connected to the wiring pattern 4, the bare chip semiconductors 7 and 8 being wire-bonded to the wiring pattern 4. The bare chip semiconductor 7, which is a heating element, is directly connected to the metal base plate 2 via the through-hole 3a in the BCB resin layer 3.

## Description

The present invention relates to an electronic circuit unit suitable for a high-frequency device and a method of manufacturing the same.

Recently, a technique for markedly enhancing the integration degree of an electronic circuit has come into wide use, for instance, by forming a capacitor or resistor of a thin film, or by wire-bonding a bare chip semiconductor to a wiring pattern, and benzocyclobutene resin (hereinafter referred to as BCB resin) has come into notice as a substrate material very suitable for such an electronic circuit. That is, since BCB resin has excellent heat resistance and adhesion and thus has low permittivity and absorption rate, it is easy to form a wiring pattern, an electrode of a circuit element, or a resistance film on a surface of the BCB resin layer.

In a conventional electronic circuit unit comprising such a BCB resin layer, a BCB resin layer of a predetermined film thickness is provided on a base plate made of glass or ceramic, and a wiring pattern, an electrode, a resistance film, and the like are provided on a surface of the BCB resin layer (for example, see Japanese Unexamined Patent Application Publication No. 9-55584 (pp. 2 and 3, Fig. 1)). When an electronic circuit for a high-frequency device is used, by interposing a ground conductor layer composed of copper foil between an insulating base plate and a BCB resin layer, a wiring pattern on a BCB resin plate is formed of a microstrip line, or the wiring pattern and the ground conductor layer are electrically connected to each other via a through-hole provided in the BCB resin layer, thereby forming a ground circuit.

Circuit elements constituting an electronic circuit are mostly encased within a shield case, but it was impossible to effectively radiate the heat generated from a BCB resin layer to the outside in the conventional electronic circuit unit in which the BCB resin layer is provided on a base plate made of glass or ceramic. That is, since heating elements, such as amplifying transistors, are provided in a high-frequency device, a great deal of heat is radiated from the heating elements in the application of voltage. However, since it is difficult for a BCB resin layer or a base plate made of glass or ceramic to transmit heat, the temperature inside the shield case increases due to the heat generated from the heating elements, creating a situation in which damage could result to other circuit elements.

Furthermore, when an electronic circuit unit used as a high-frequency device is mounted on a motherboard (main board), it is preferable that the electronic circuit unit be connected to the ground of an external circuit to enhance the grounding effect. However, in order to connect the ground conductor layer interposed between the base plate and the BCB resin layer to a ground region on the motherboard side, with the base plate made of glass or ceramic provided on the motherboard, an end face electrode had to be previously attached to the electronic circuit unit, or the electronic circuit unit had to be mounted on the motherboard by wire-bonding. Therefore, it was not easy to connect the ground of the external circuit in order to enhance the grounding effect in such a conventional electronic circuit unit.

The present invention is designed to solve the above-mentioned problems. Accordingly, it is an object of the present invention to provide an electronic circuit unit capable both of effectively radiating the heat generated from a BCB resin layer and of readily connecting with the ground of an external circuit.

In order to achieve the above-mentioned object, an electronic circuit unit according to the present invention comprises a base plate made of metal, a benzocyclobutene resin layer provided on a surface of the base plate, through-holes provided in the benzocyclobutene resin layer, a wiring pattern provided on a surface of the benzocyclobutene resin layer, and a plurality of circuit elements connected to the wiring pattern.

In the electronic circuit unit with such constitution, since circuit elements radiating a great quantity of heat (heating elements) can be directly brought into contact with a base plate made of metal via through-holes in the BCB resin layer, or both of them can be brought into contact with each other by solder within the through-holes, it is possible to effectively radiate heat to the outside by transmitting the heat from the heating elements to the metal base plate.

Provided that the circuit elements constituting such an electronic circuit unit include capacitors and resistors, which are formed of a thin film, and bare chip semiconductors, which are wire-bonded to a wiring pattern, it is easy to raise the degree of integration, thereby miniaturization the electric circuit unit.

In addition, in such an electronic circuit unit, if the wiring pattern on the BCB resin layer is formed of a microstrip line using the base plate as the ground, it is easy to control the impedance of the wiring pattern when the electronic circuit unit is used as a high-frequency device.

Furthermore, in such an electronic circuit unit, if a ground circuit is formed by electrically connecting the wiring pattern to the base plate via the through-holes in the BCB resin layer, the ground circuit can be formed in common with the ground of the external circuit only by connecting the base plate to a ground region on the motherboard side, thereby readily improving the grounding effect.

In order to achieve the above-mentioned object, a method for manufacturing an electronic circuit unit according to the present invention comprises the steps of: forming a benzocyclobutene resin layer on a surface of a base plate made of metal; forming through-holes in the benzocyclobutene resin layer; and forming a wiring pattern on a surface of the benzocyclobutene resin layer.

Since the electronic circuit unit manufactured in such a manner can utilize the metal base plate as the ground, there is no need to provide an additional ground conductor layer, thereby reducing the number of required processes.

Moreover, in such a manufacturing method, if the BCB resin layer is formed by a spin coating method, it is possible to equalize the film thickness of the BCB resin layer. When the BCB resin layer is formed by the spin coating method, it is preferred that the step of forming through-holes by exposing and etching a portion of the BCB resin layer which is formed to a predetermined film thickness be included. However, the BCB resin layer may be formed by a printing method. In this case, cost can be reduced since productivity is improved.

In addition, in such a manufacturing method, when the wiring pattern of a thin film is formed by a sputtering method, it is possible to perform high-density patterning, thereby miniaturizing the electronic circuit unit. However, the wiring pattern of a thick film may be formed by a printing method, and in that case, cost can be reduced since productivity is improved.

The present invention is carried out in the above-mentioned manner and has the following advantages.

In an electronic circuit unit according to the present invention, since circuit elements radiating a great quantity of heat (heating elements) can be brought into contact with the base plate made of metal via the through-holes in the BCB resin layer, it is possible to effectively radiate heat to the outside by transmitting the heat generated from the heating elements to the base plate. In addition, in the event that a ground circuit is formed by electrically connecting the wiring pattern to the base plate via the through-holes in the BCB resin layer, the ground circuit can be formed in common with the ground of the external circuit only by connecting the base plate to a ground region on the motherboard side, thereby readily improving the grounding effect.

In addition, since a method for manufacturing an electronic circuit unit according to the present invention can utilize a metal base plate as the ground, there is no need to provide an additional ground conductor layer, thus reducing the number of required processes. Furthermore, it is easy to equalize film thickness if the BCB resin layer of a thin film is formed by a spin coating method, and it is easy to improve productivity if the BCB resin layer of a thick film is formed by a printing method.

Reference will now be made to the embodiments of the present invention in conjunction with the drawings.
Fig. 1 is a cross-sectional view showing a main part of an electronic circuit unit according to an embodiment of the present invention.
Fig. 2 is a diagram showing the entire configuration of the electronic circuit unit.
Fig. 3 is a diagram showing the manufacturing process of the electronic circuit unit.

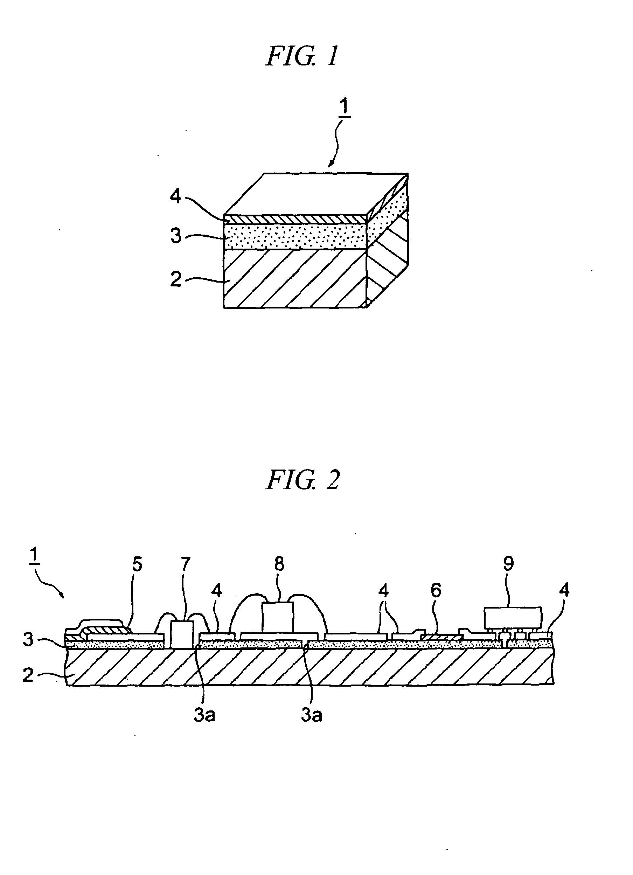

In Figs. 1 and 2, an electronic circuit unit denoted by reference numeral 1 is used as a high-frequency device and is mounted on a motherboard (main board)(not shown). The electronic circuit unit 1 comprises a base plate 2 made of metal, a BCB resin layer 3 of a certain film thickness provided on a surface of the base plate 2, a wiring pattern 4 as a conduction path provided on a surface of the BCB resin layer 3, and a plurality of circuit elements connected to the wiring pattern 4. The circuit elements includes a thin film capacitor 5, a thin film resistor 6, bare chip semiconductors 7 and 8, and a flip chip IC 9, and the bare chip semiconductors 7 and 8 are wire-bonded to the wiring pattern 4. Therefore, the electronic circuit of the electronic circuit unit facilitates improvement in the degree of integration, thereby miniaturizing the electric circuit unit.

The base plate 2 is preferably composed of a plate made of Al or Cu, or a Ni-plate iron plate. Large or small through-holes 3a are provided at predetermined positions on the BCB resin layer 3. A ground circuit is formed by electrically connecting the base pattern 4 to the base plate 2 via the through-holes 3a. In addition, the wiring pattern 4 is mostly formed of the microstrip line using the base plate 2 as the ground.

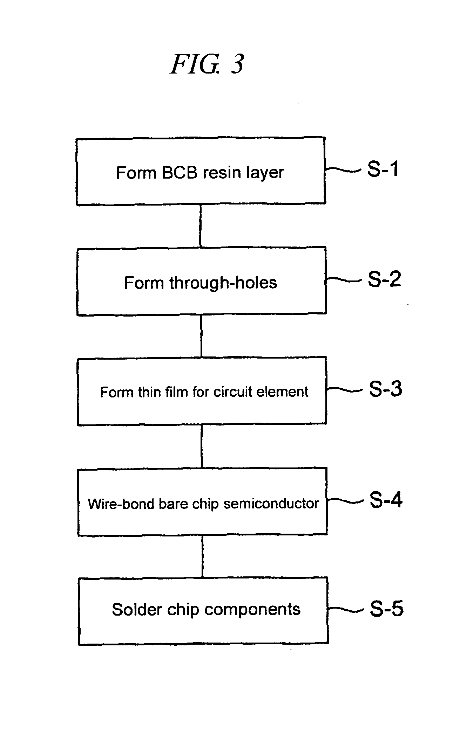

The above-mentioned electronic circuit unit 1 is fabricated in the following sequence. That is, as shown in Fig. 3, the BCB resin layer 3 of a predetermined thickness is formed by applying and drying BCB resin on a surface of the base plate 2 to a certain film thickness using a spin coating method (S-1). Subsequently, through-holes 3a are formed by exposing and etching portions of the BCB resin layer 3 (S-2). However, the BCB resin layer 3 having the through-holes 3a may be formed by printing and drying BCB resin on a surface of the base plate 2.

Next, a wiring pattern 4, a thin film capacitor 5, a thin film resistor 6, and the like are formed as a thin film on a surface of the BCB resin layer 3 by a sputtering method (S-3). That is, the wiring pattern 4 and electrodes of the thin film capacitor 5 are formed by sputtering of Cu or Cr followed by etching, a thin film resistor 6 is formed by sputtering of TaSiO₂ followed by etching, and a dielectric film of the thin film capacitor 5 is formed by sputtering of SiO₂ followed by etching. However, the wiring pattern 4, the thin film capacitor 5, and the thin film resistor 6 may be formed as a thick film on a surface of the BCB resin film 3 by a printing method, and the wiring pattern 4, for instance, may be formed by printing and drying Ag paste and the like.

Subsequently, a plurality of bare chip semiconductors 7 and 8 is die-bonded to the wiring pattern 4 or the base plate 2 via the through-holes 3a, and electrodes on the surfaces of the respective bare chip semiconductors 7 and 8 and the wiring pattern 4 corresponding to the electrodes are then connected to each other by wire bonding (S-4). Furthermore, before and after this process, cream solder is applied on the wiring pattern 4, which is the connection land, and then a variety of chip components including a flip chip IC 9 is mounted thereon. Then, these chip components are soldered by heating in a reflow furnace (S-5).

For an electronic circuit unit 1 fabricated in the aforementioned manner, since a bare chip semiconductor 7 (for example, an amplifying transistor), which is a heating element, can be directly connected to the metal base plate 2 via the through-hole 3a in the BCB resin layer 3, it is possible to effectively radiate heat to the outside by transmitting the heat generated from the heating element to the base plate 2. In addition, while not shown, it is possible to improve a radiation effect by connecting the heating element to base plate 2 through solder filled within the through-hole 3a of the BCB resin layer 3.

In addition, since the wiring pattern 4 is mostly formed of a microstrip line using the base plate 2 as the ground in the electronic circuit unit 1, it is easy to control the impedance of the wiring pattern 4, resulting in facilitation of the design. Furthermore, in the electronic circuit unit 1, since a ground circuit is formed by electrically connecting the wiring pattern 4 to the base plate 2 via the through-holes 3a, the ground circuit can be formed in common with the ground of the external circuit only by connecting the base plate 2 to a ground region on the motherboard side, thereby readily improving the grounding effect.

In addition, since the base plate 2 made of metal is utilized as the ground in the electronic circuit unit 1, there is no need to provide an additional ground conductor layer, thereby reducing the number of required processes. Furthermore, the employment of a spin coating method as a forming method of the BCB resin layer 3 facilitates obtaining a BCB resin layer 3 of a uniform film thickness, and the employment of a printing method facilitates a reduction in cost since productivity is improved. Moreover, the employment of a sputtering method as a forming method of the wiring pattern 4 facilitates miniaturization since high-density patterning can be performed, and the employment of a printing method facilitates a reduction in cost since productivity is improved.

### Reference Numerals:

1: ELECTRONIC CIRCUIT UNIT
2: BASE PLATE
3: BENZECYCLOBUTENE (BCB) RESIN LAYER
3a: THROUGH-HOLE
4: WIRING PATTERN
5: THIN FILM CAPACITOR
6: THIN FILM RESISTOR
7, 8: BARE CHIP SEMICONDUCTOR
9: FLIP CHIP IC

## Claims

1. An electronic circuit unit comprising:
a base plate made of metal;
a benzocyclobutene resin layer provided on a surface of the base plate;
through-holes provided in the benzocyclobutene resin layer;
a wiring pattern provided on a surface of the benzocyclobutene resin layer; and
a plurality of circuit elements connected to the wiring pattern.

2. An electronic circuit unit according to Claim 1,
wherein the plurality of circuit elements comprises a capacitor and a resistor formed of a thin film, and bare chip semiconductors wire-bonded to the wiring pattern.

3. An electronic circuit unit according to Claim 1 or 2,
wherein the wiring pattern is formed of a microstrip line using the base plate as the ground.

4. An electronic circuit unit according to any one of Claims 1 to 3,
wherein a ground circuit is formed by electrically connecting the wiring pattern to the base plate via the through-holes.

5. A method for manufacturing an electronic circuit unit comprising the steps of:
forming a benzocyclobutene resin layer on a surface of a base plate made of metal;
forming through-holes in the benzocyclobutene resin layer; and
forming a wiring pattern on a surface of the benzocyclobutene resin layer.

6. A method for manufacturing an electronic circuit unit according to Claim 5,
wherein the benzocyclobutene resin layer is formed by a spin coating method.

7. A method for manufacturing an electronic circuit unit according to Claim 6,
wherein the through-holes are formed by exposing and etching parts of the benzocyclobutene resin layer.

8. A method for manufacturing an electronic circuit unit according to Claim 5,
wherein the benzocyclobutene resin layer is formed by a printing method.

9. A method for manufacturing an electronic circuit unit according to any one of Claims 5 to 8,
wherein the wiring pattern is formed of a thin film by a sputtering method.

10. A method for manufacturing an electronic circuit unit according to any one of Claims 5 to 8,
wherein the wiring pattern is formed of a thick film by the printing method.
